Europäisches Patentamt

**European Patent Office**

Office européen des brevets

(19)

(11) Publication number: **0 001 138**

**A1**

(12) **EUROPEAN PATENT APPLICATION**

(21) Application number: **78200150.7**

(22) Date of filing: **21.08.78**

(51) Int. Cl.²: **G 03 F 7/02**
**G 03 G 13/28**

(30) Priority: **23.08.77 US 827057**

(43) Date of publication of application:
**21.03.79 Bulletin 79/6**

(84) Designated contracting states:
**BE DE FR GB NL SE**

(71) Applicant: **Fromson, Howard A.**
**15 Rogues Ridge Road**
**Weston Connecticut 06066(US)**

(72) Inventor: **Fromson, Howard A.**
**15 Rogues Ridge Road**
**Weston Connecticut 06066(US)**

(72) Inventor: **Gracia, Robert F.**
**451 First Parish Road**
**Scituate Massachusetts 02066(US)**

(74) Representative: **Schulze Horn, Stefan, Dipl.-Ing. et al,**
**Goldstrasse 36**
**D-4400 Münster(DE)**

(54) **Method for making lithographic printing plates.**

(57) Lithographic printing plates are prepared by:
1) providing a sensitized lithographic substrate (10) having a photochemical coating (12) thereon that has its solubility altered upon exposure to actinic radiation (for example an anodized aluminium substrate (10) coated with a UV sensitive diazo resin);
2) depositing on selected portions of the sensitized substrate a layer of non-silver halide material (14) that is opaque to the actinic radiation that will alter the solutility characteristics of the photochemical coating (this forms a so-called fugitive negative on the sensitized substrate and electrostatic or laser transfer techniques can be used for forming the fugitive negative);
3) exposing the sensitized substrate to actinic radiation to alter the solubility characteristics of the uncovered portions of the photochemical coating; and
4) dissolving away the soluble portions of the photochemical coating. If desired the non-silver halide fugitive negative can be removed after exposing the sensitized substrate.

FIG. I.
U. V. SOURCE

NON-SILVER HALIDE OPAQUE MASK
PHOTOCHEMICAL LAYER (E.G. DIAZO RESIN)
FIG. 2.
SUBSTRATE (E.G. ANODIZED ALUMINUM)
INSOLUBLE AREA

EP 0 001 138 A1

## BACKGROUND

This invention relates to lithographic printing and more particularly to the preparation of lithograpic printing plates using non-silver halide techniques.

Lithographic printing techniques, using, for example, aluminum base plates such as described in Fromson patent US 3,181,461 issued May 4, 1965, have come into wide use in the printing industry and especially in offset lithographic printing and direct lithographic printing by newspaper using converted letterpress printing presses.

Time is often a factor in making lithographic printing plates and this is especially critical in the case of newspapers. The present-day technique involves making a full size photographic negative of a paste-up of each page for the newspaper and then exposing a wipe-on or pre-sensitized lithographic plate through the negative followed by developing after which the plate is ready for mounting on the printing press. This process is time consuming and becomes even less efficient where duplicate plates are required for a multiple press operation which is common in the newspaper industry.

In order to improve the time element involved in making lithographic printing plates it has been proposed to eliminate the use of a light sensitive lithographic substrate, such as a diazo resin coated anodized aluminum substrate, and to instead directly reproduce the printing surface on the substrate using electrostatic techniques and laser transfer techniques. US-Patent 2,862,815 issued December 2, 1958 describes a direct reproduction process using electrostatic techniques and US-Patents 2,962,513 issued June 8, 1976 and 3,964,389 issued June 22, 1976 describe laser transfer techniques for forming the printing surface on a substrate. However, these proposals have not met with much success because the printing surface formed using these direct reproduction techniques lacks the integrity and durability required for good quality, dependable lithographic printing. In other words, these proposals have failed to come up to the quality and durability standards available from conventional photochemical materials used in pre-sensitized and wipe-on printing plates, for example diazo resins.

Another proposal is set forth in US-Patent 3,578,451 issued May 11, 1971 and involves applying a conventional photographic emulsion over the diazo coating on a lithographic substrate. The phtographic emulsion coating is exposed to form an _in situ_ fugitive negative which is later removed after or during development of the diazo printing surface. This proposal, however, utilizes conventional photographic techniques and suffers from drawbacks associated therewith. For example substrates prepared in this fashion must be prepared, stored and handled under darkroom conditions and this only adds rather than subtracts from the procedures to be followed by the lithographic plate maker.

- 3 -

0001138

## SUMMARY

The present invention provides a photographic method for making high quality dependable lithographic printing plates in a highly efficient manner. The present invention makes it possible to employ conventional sensitized lithographic substrates for example pre-sensitized or wipe-on printing plates and relies on the use of more advanced techniques for forming a fugitive negative over the sensitized substrate.

The process according to the present invention for making a lithographic printing plate thus includes the steps of:

    a) providing a sensitized lithographic substrate having a photochemical coating thereon that has its solubility altered upon exposure to actinic radiation;

    b) depositing on selected portions of the sensitized substrate a layer of a non-silver halide material that is opaque to the actinic radiation that will alter the solubility of the photochemical coating;

    c) exposing the sensitized substrate to actinic radiation to alter the solubility characteristics of the uncovered portions of the photochemical coating; and

    d) dissolving away the soluble portions of the photochemical coating.

Step b) above involves the formation of a fugitive negative on the sensitized substrate and this can be accomplished according to preferred embodiments of the invention using electrostatic and laser transfer techniques.

- 4 -

0001138

## DESCRIPTION OF THE DRAWING

The present invention will be more fully understood from the following description taken in conjunction with the accompanying drawing wherein:

Fig. 1 is a cross-sectional diagrammatic view illustrating one embodiment of the present invention;

Fig. 2 is a cross-sectional diagrammatic representation of a lithographic printing plate formed according to the embodiment illustrated in Fig. 1;

Figs.3 - 5 are cross-sectional diagrammatic representations illustrating another embodiment of the invention utilizing laser transfer techniques; and

Figs.6 and 7 are cross-sectional diagrammatic representations of lithographic printing plates formed according to the embodiment illustrated in Figs. 3 - 5.

## DESCRIPTION

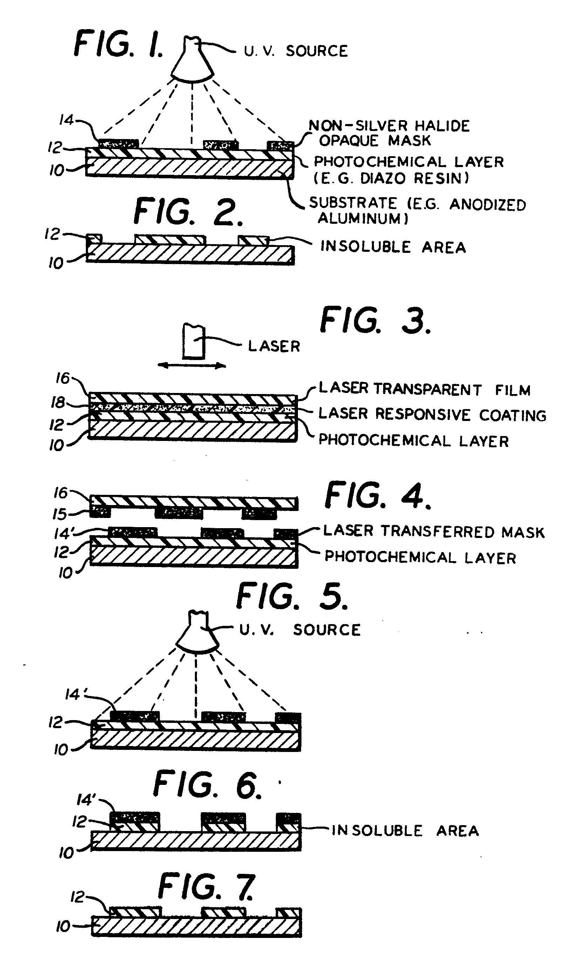

Fig. 1 of the drawing provides a simple illustration of the present invention wherein a substrate 10 for example anodized aluminum is provided with a photochemical layer or coating 12 that has its solubility altered upon exposure to actinic radiation, for example a coating of diazo resin. A non-silver halide opaque mask or fugitive negative 14 is deposited on selected portions of the sensitized substrate. The mask 14 is opaque to actinic radiation that will alter the solubility of the photochemical coating 12. After depositing the mask 14, the uncovered portions of the photochemical coating 12 are exposed to actinic radiation which in this illustration is

- 5 -

0001138

a source of ultra violet radiation as shown in Fig. 1. This alters the solubility characteristics of the photochemical layer 12 in those portions left uncovered by the mask 14.

In the embodiment shown in Figs. 1 and 2, a negative working diazo resin is employed which becomes insoluble in those areas which see the UV light, that is the portions not covered by the mask 14. In developing the exposed sensitized substrate, the opaque mask 14 is removed and the underlying unexposed and still soluble portions of the diazo resin coating are also removed using conventional developing techniques. The plate shown in Fig. 2 results with an insoluble diazo resin in the image areas of the plate.

Figs. 3 through 7 illustrate another embodiment of the invention wherein a laser transfer technique is employed with a positive acting diazo resin. A laser transparent film 16 having thereon a laser responsive coating 18 is placed face down on the sensitized substrate which is made up of the substrate 10 and the photochemical layer 12. A laser is employed to transfer portions of the laser responsive coating 18 from the film 16 onto the photochemical layer 12 resulting in the fugitive negative 14' (Fig. 4). Using known techniques, a so-called reading laser causes the so-called writing laser to transfer the laser coating 18 in the image areas illustrated by reference numeral 14'. Exposure to a UV source of light as shown in Fig. 5 causes the uncovered portions of the photochemical layer 12 to become solubilized in the case of a positive working diazo resin. The solubilized portions of the photochemical layer are then removed by conventional developing techniques lea ing an insoluble image area which still carries the transferred fugitive negative 14'. If desired the transferred portions of the laser coating 18 (14' in Fig. 6) can be removed leaving the developed plate as shown in Fig. 7.

It should be understood that the laser transparency with the portions 15 (fig. 4) remaining after the laser transfer operation can be used with a negative working diazo resin as a negative itself to produce duplicate lithographic printing plates.

The lithographic substrate is preferably an anodized and treated aluminum substrate such as described in Fromson patents US 3,181,461 and US 3,280,734. Tempered aluminum is generally used to make lithographic substrates which are suitable for use in the present invention. Tempered aluminum generally has a temper rating of between H-12 and H-19 where direct cold reduction is employed or between H-23 and H-27 where a combination of cold reduction and back annealling are employed. See the American Aluminum Association publication entitled Aluminum Standards and Data.

The sensitized lithographic substrate used in the invention can be made in a number of ways known in the art for example as taught by the following patents;

| US 2,714,066 | Jewitt et al | July 26, 1955 |
| US 2,741,981 | Frost | April 17, 1956 |
| US 2,791,504 | Plambeck | May 7, 1957 |
| US 3,062,648 | Crawford | November 6, 1962 |
| US 3,220,346 | Strickler | November 30, 1965 |
| US 3,336,164 | Webers | August 29, 1967 |

A preferred substrate is an anodically oxidized aluminum member which is treated after anodizing with an alkali metal silicate and sealed prior to being sensitized. This is described in greater detail in Fromson patent US 2 181,461 referred to previosly.

It is preferred to continuously anodize aluminum for the preferred aluminum substrate utilizing the anodizing techniques described in Fromson patents US 3,865,700 issued February 11, 1975 and US 3,920,525 issued November 18, 1975. If desired, the aluminum substrate can be provided with a composite anodized and discontinuously electroplated surface prior to application of the photochemical layer as described in greater detail in Fromson patent US 3, 929,594 issued December 30, 1975.

As mentioned above, the photochemical layer 12 can be negative working or positive working. Negative working light sensitive materials are of such a nature that before exposure to actinic radiation they are soluble in a particular solvent (usually water). When exposed to actinic radiation, however, the material becomes insoluble in the solvent. Positive working light sensitive materials function just the opposite, that is, they are insoluble and become soluble upon exposure to actinic radiation.

Thus, for purposes of the present invention, the light sensitive material forming the photochemical layer 12 on the lithographic substrate 10 has one solubility in relation to a solvent in a state bevore expsure to actinic radiation and another solubility in relation to said solvent in another state after exposure to actinic radiation, the light sensitive material being soluble in said solvent in one of said states and being insoluble in said solvent in its other state.

The light sensitive material forming the photochemical layer 12 can be formed from a host of photochemical materials known in the art. Such light sensitive materials include dichromated colloids, such as those based on organic colloids, gelatin, · process glue, albumens, caseins, natural gums, starch and its derivatives, synthetic resins, such as polyvinyl alcohol and the like; unsaturated compounds such as those based on cinnamic acid and its derivatives, chalcone type compounds, stilbene compounds and the like; and photopolymerizable compositions, a wide variety of polymers including vinyl polymers and

- 8 -

0001138

copolymers such as polyvinyl alcohol, polyvinyl acetals, polyvinyl acetate vinyl sorbate, polyvinyl ester acetal, polyvinyl pyrrolidone, polyvinyl butyrol, halogenated polyvinyl alcohol; cellulose based polymers such as cellulose-acetate hydrogenphthalate, cellulose alkyl ethers; ureaformaldehyde resins; polyamide condensation polymers; polyethylene oxides; polyalkylene ethers, polyhexamethylene adipamide; polycholoro-phene; polyethylene glycols, and the like. Such compositions utilize as initiators carbonyl compounds, organic sulphur compounds, peroxides, redox systems, azo und diazo compounds, halogen compounds and the like. These and other photochemical materials including their chemistry and uses are discussed in detail in a text entitled Light-Sensitive Systems, Jaromir Kosar, John Wiley and Sons, Inc., New York, 1965. Diazo resins are particularly preferred.

As used herein, the terms "soluble" and "insoluble" are intended to convey the meaning generally accepted and understood in the art of exposing and developing images using light sensitive systems. For example a light sensitive material is considered to be soluble when it can be readily removed by washing with an particular solvent at normal operating temperatures such as room temperature and insoluble when it is not removed upon exposure to a particular solvent under the same or similar temperature conditions.

The non-silver halide opaque mask 14 can be deposited onto the photochemical layer 12 of the sensitized substrate, using known electrostatic techniques such as xerography, zinc oxide imaging, charge transfer imaging and the like. US Patent 2,862,815, referred to previously and US Patents 3,671,119 and 3,671,120 both issued June 20, 1972 are examples of such electrostatic techniques and are incorporated herein by way of reference. Charge transfer copiers are sold by the Minolta Camera Company.

The preferred method for depositing the opaque mask 14' is a laser transfer process which is illustrated in Figs. 3 through 7 of the drawing and described in greater detail in US Patents 3,962,513 issued June 8, 1976 and 3,964,389 issued June 22, 1976 both of which are incorporated herein by way of reference. Other suitable laser transfer techniques are described in US 3,745,586 issued July 10, 1973 and US 3,787,210 issued January 22, 1974, both of which are incorporated herein by reference.

Basically what is involved in using a laser transfer technique to form the mask 14' (Fig. 4) is to employ a laser transparent film such as a polyester film coated with a formulation containir a material which absorbs laser energy, that is, responsive to a laser energy, such as carbon black particles (if the laser is a YAG type), and a binder such as nitrocellulose. To transfer selected portions of the laser responsive coating to the sensitized substrate, a beam of energy from a laser which produces radiation in the infrared region such as a YAG (Yttrium-Aluminum-Garnet) laser which has an effective output at about 1.06 microns, or an Argon laser which has an effective output in the range of from about 0.48 to about 0.52 microns, is focused by means known in the art through the laser transparer film to the interface between the coating and the film. The energy provided by the laser beam causes a blow-off which carries with it the heat absorbing particles and the binder leaving a clear area on the laser transparent film 16 (see Fig. 4).

Materials suitable as constituents in the laser response coating 18 for forming the mask 14 include thermoplastic polymers such as cellulose acetate, cellulose acetate butyrate, nylon, polycarbonate, polyacylatic, polyvinyl butyrol, phenolics, and the like; therosetting polymers such as epoxy, phenolics, melamines and the like; vacuum metalized films such as Al, Cr, Ni, Ni-Cr, In, Sn, Bi, Ag, Cu, and the like; waxes such as beeswax, candelilla, carnauba, Chinese, Japan wax, microcrystalline wax, paraffin, shellac, and the like. Also dyes, ink and paints may be utilized. Opaqueing constituents may be necessary and they include carbon black, graphite and colored pigments -- organic an inorganic -- which are selective absorbers for the particular wave length of laser light being used. In addition, oxidizable or explosive constitutents may be used to encourage transfer and/or increase sensitivity. Materials in this catetory are nitrocellulose, peroxides, azides and nitrates.

In a preferred embodiment, the substrate 10 is sensitized with a negative diazo resin such as the zinc chloride salt of the condensation reaction between p-diazo-diphenylamine and formaldehyde, a negative image mask is deposited on the diazo sensitized plate using a laser transfer film the unmasked areas are exposed to UV, and developed with a conventional wipe-on lacquer to produce a positive image on the plate while leaving a positive image on the laser transfer film. Duplicate plates can be made from this laser film by exposing a positive working plate through the film and developing in the conventional fashion.

In another embodiment, the substrate is sensitized with an o-quinone diazide type of positive working coating, a positive image mask is deposited on the coated plate using a laser transfer film, the unmasked background areas are exposed to UV and developed with a suitable developer to produce a positive image on the plate while leaving a negative image on the laser transfer film. Duplicate plates can be made using this film to expose a negative working plate.

In addition to producing lithographic plates, the invention is ideally suited to making name and sign plates and the like.

## EXAMPLE I

A negative working diazo coating (3 % diazo) sold under the name Diazo Resin No 4 (sold by Fairmont Chemical Co.), was applied to an aluminum substrate by means of a two-roll coater. The aluminum substrate was previosly chemically grained in ammonium bifluoride; sulfuric acid anodized and silicated. The coated (presensitized) plate was then placed in a laser plate-maker developed by Lo gEtronics Corporation of Springfield, Virginia. The plate was covered with a laser transfer film made by Scott Graphics of Scott Paper Company. The plate was masked as follows:

A "read" laser reads a paste-up positive. Then an imaging YAG laser was made to pulse in the reverse mode, i. e. it will transfer the masking material in the background, that is, the non-image areas only. In this way a positive image was created on the masking film and a negative image was transferred to the underlying plate. The masked plate was then exposed to UV. This exposure affected only the unmasked areas of the plate. Upon lacquering, the unmasked areas developed to a strong positive image due to the exposed diazo. Simultaneously, the masked areas (the negative image) were removed. In this way a positive imaged plate is made using a negative working photo sensitive material.

## EXAMPLE II

A positive working photo sensitive plate, made by Howsen-Algraphy, called at Alympic plate, was placed in a laser plate-maker developed by the LogEtronics Corporation. The laser was used in the conventional mode, i. e. the "read" laser reads positive copy and the "write" laser (YAG) transfers a positive image. In the plate-maker, the positive plate was covered with the same laser film used in Example I. The YAG laser ablated the mask in a positive fashion leaving a negative image on the film mask and a positive image on the underlying positive working plate. The positive working plate carrying the positive mask was removed from the laser plate-maker and blanket exposed with UV light. The masked areas are not affected by this exposure and the unmasked areas are rendered soluble. Thus, a positive imaged plate is prepared using a positive working photo sensitive coating via a laser masking technique.

EXAMPLE III

A positive working photo sensitive plate, as used in Example II is xerographically imaged and toned. The toner particles are then fused, thereby masking the image areas. The non image areas are then exposed to UV light effecting a solubility change. The plate is developed in the usual manner and made ready for the press.

EXAMPLE IV

A positive working, photo sensitive plate, as used in Example II, is imaged using a Minolta Electrographic charge transfer copier. The aluminum substrate is anodized on the image side only leaving the back conductive for the charge transfer process. The toner particles in the deposited image are fused to mask the underlying areas as the plate. The plate is developed in the usual fashion and made ready for the press.

WHAT IS CLAIMED IS:

1. Process for making a lithographic pringing plate which comprises:

   (a) providing a sensitized lithographic substate having a photochemical coating thereon that has its solubility altered upon exposure to actinic radiation;

   (b) depositing on selected portions of the sensitized substrate a layer of a non-silver halide material that is opaque to the actinic radiation that will alter the solubility of the photochemical coating;

   (c) exposing the sensitized substrate to actinic radiation to alter the solubility characteristics of the uncovered portions of the photochemical coating; and

   (d) dissolving away the soluble portions of the photochemical coating.

2. Process of claim 1 wherein the non-silver halide material is deposited by xerography.

3. Process of Claim 1 wherein the non-silver halide material is deposited on selected portions of the sensitized substrate by laser transfer.

4. Process of claim 3 wherein the sensitized substrate is contacted with a film transparent to laser radiation having thereon a laser responsive coating comprising said non-silver halide material and selected irradiation with a laser causing said laser responsive coating to become deposited on selcted portions of the sensitized substrate.

5. Process of claim 4 wherein the substrate is sensitized with a negative diazo resin and laser irradiation produces a negative image mask on the diazo sensitized plate.

6. Process of claim 4 wherein the substrate is sensitized with a positive working diazide type coating and laser irradiation produces a positive image mask on the coated plate.

7. Process of claim 1 wherein the non-silver halide material is deposited by charge transfer imaging.

## FIG. 1.

U.V. SOURCE

14 — NON-SILVER HALIDE OPAQUE MASK

12 — PHOTOCHEMICAL LAYER (E.G. DIAZO RESIN)

10 — SUBSTRATE (E.G. ANODIZED ALUMINUM)

## FIG. 2.

12 — INSOLUBLE AREA

10

## FIG. 3.

LASER

16 — LASER TRANSPARENT FILM

18 — LASER RESPONSIVE COATING

12 — PHOTOCHEMICAL LAYER

10

## FIG. 4.

16

15

14' — LASER TRANSFERRED MASK

12 — PHOTOCHEMICAL LAYER

10

## FIG. 5.

U.V. SOURCE

14'

12

10

## FIG. 6.

14'

12 — INSOLUBLE AREA

10

## FIG. 7.

12

10

266

European Patent
Office

**EUROPEAN SEARCH REPORT**

Application number

EP 78 20 0150

| Category | DOCUMENTS CONSIDERED TO BE RELEVANT | | CLASSIFICATION OF THE APPLICATION (Int. Cl.²) |
|---|---|---|---|
| | Citation of document with indication, where appropriate, of relevant passages | Relevant to claim | |
| X | JP - A - 52/76 105 (NIPPON PAINT)<br>* The abstract; the figures; the claims; column 3, lines 3-59 * | 1,2 | G 03 F 7/02<br>G 03 G 13/28 |
| P/X | & US - A - 4 044 385 (M.NISHIMURA)<br>--- | | |
| | US - A - 2 939 787 (E.C. GAIMO)<br>* The claims; the figures; column 7, lines 27-50; column 2, lines 14-64; column 3, line 16 to column 7, line 25 *<br>--- | 1,2 | |
| | PROCEEDINGS OF THE NATIONAL ELECTRONICS CONFERENCE, vol. 24, December 1, 1968;<br>Chicago, USA<br>R.M. LUMLEY et al. "The laser as a manufacturing tool for the semi-conductor industry", pages 859-861.<br>* Page 859, column 2, paragraphs 3-4 *<br>--- | 3,4 | TECHNICAL FIELDS SEARCHED (Int.Cl.²)<br><br>G 03 F 7/02<br>7/20<br>7/08<br>G 03 G 13/28<br>13/26 |
| A/D | US - A - 3 578 541 (T. DOGGETT)<br>* The claims; the figures; the abstract *<br>--- | 5 | |
| A | US - A - 3 046 124 (M.P. SCHMIDT)<br>* The claims; the figures; column 2, lines 15-50 *<br>----- | 6 | CATEGORY OF CITED DOCUMENTS<br><br>X: particularly relevant<br>A: technological background<br>O: non-written disclosure<br>P: intermediate document<br>T: theory or principle underlying the invention<br>E: conflicting application<br>D: document cited in the application<br>L: citation for other reasons<br><br>&: member of the same patent family, corresponding document |

The present search report has been drawn up for all claims

| Place of search | Date of completion of the search | Examiner |
|---|---|---|
| The Hague | 30-11-1978 | VANHECKE |

EPO Form 1503.1   06.78